# EUROPEAN PATENT SPECIFICATION

(11) **EP 4 411 835 B1**
(45) Date of publication and mention of the grant of the patent: **01.04.2026**
(21) Application number: 24182027.3
(22) Date of filing: 13.06.2024
(51) Int. Cl.: H10F 10/165, H10F 71/00, H10F 77/20, H10F 77/30

(54) **SOLAR CELL, PREPARATION METHOD THEREOF AND PHOTOVOLTAIC MODULE**
SOLARZELLE, HERSTELLUNGSVERFAHREN DAFÜR UND FOTOVOLTAISCHES MODUL
CELLULE SOLAIRE, SON PROCÉDÉ DE PRÉPARATION ET MODULE PHOTOVOLTAÏQUE

(30) Priority: 09.08.2023 CN 202310996038
(43) Date of publication of application: 07.08.2024
(73) Proprietor: Trina Solar Co., Ltd, Changzhou, Jiangsu 213031 (CN)
(72) Inventor: WANG, Zigang, CHANGZHOU, 213031 (CN); WU, Kuiyi, CHANGZHOU, 213031 (CN)
(74) Representative: Arnold & Siedsma

(56) References cited:
- CN-A- 114 709 294
- CN-A- 115 148 857
- CN-A- 115 700 925
- CN-A- 116 504 858
- US-A1- 2023 006 086
- DAS UJJWAL ET AL: "Processing Approaches and Challenges of Interdigitated Back Contact Si Solar Cells", 2017 IEEE 44TH PHOTOVOLTAIC SPECIALIST CONFERENCE (PVSC), IEEE, 25 June 2017 (2017-06-25), pages 1761 - 1764, XP033454311, DOI: 10.1109/PVSC.2017.8366709
- XU MENGLEI ET AL: "Simple emitter patterning of silicon heterojunction interdigitated back-contact solar cells using damage-free laser ablation", SOLAR ENERGY MATERIALS AND SOLAR CELLS, ELSEVIER SCIENCE PUBLISHERS, AMSTERDAM, NL, vol. 186, 22 June 2018 (2018-06-22), pages 78 - 83, XP085427576, ISSN: 0927-0248, DOI: 10.1016/J.SOLMAT.2018.06.027

## Description

This application claims priority to Chinese patent application No. 202310996038.8, filed on August 9, 2023, and titled "SOLAR CELL, PREPARATION METHOD THEREOF AND PHOTOVOLTAIC MODULE".

### TECHNICAL FIELD

The present application relates to the technical field of solar cells, and in particular to a solar cell, a preparation method thereof, and a photovoltaic module.

### BACKGROUND

With the development of solar cell technology, tunnel oxide passivated contact (TOPCon) technology has emerged, which involves forming an ultra-thin tunnel oxide layer on a surface of a crystalline silicon wafer and stacking a doped polysilicon layer on the tunnel oxide layer, thereby obtaining a passivating contact structure. The passivating contact structure can significantly reduce charge carrier recombination in the metal contact area while achieving desirable contact performance, thereby effectively enhancing the efficiency of the solar cell. However, the polysilicon layer in the passivating contact structure exhibits severe parasitic absorption of light. A thick polysilicon layer formed across the entire surface of the silicon wafer will greatly reduce the utilization rate of light, decreasing the short-circuit current, which leads to current loss, limiting further improvements of the open-circuit voltage and conversion efficiency of the solar cell. The related technologies are known from CN115148857A, US2023006086A1, CN115700925A, CN114709294A, CN116504858A, the article "Processing Approaches and Challenges of Interdigitated Back Contact Si Solar Cells", Das et al., IEEE 44TH PVSC, 25 June 2017, p. 1761-1764 and the article "Simple emitter patterning of silicon heterojunction interdigitated back-contact solar cells using damage-free laser ablation", Xu et al., Solar Energy Materials and Solar Cells 186 (2018) 78-83.

### SUMMARY

In view of the above, there is a need to provide a solar cell, a preparation method thereof, and a photovoltaic module. The invention is set out in the appended set of claims.

According to a first aspect, a solar cell includes:
a silicon substrate;
a tunnel oxide layer disposed on a surface of the silicon substrate;
a first doped polysilicon layer disposed on a surface of the tunnel oxide layer, a surface of the first doped polysilicon layer including a metal contact region and a non-metal contact region;
a laser-absorption layer disposed on the metal contact region of the surface of the first doped polysilicon layer, the laser-absorption layer is adapted to be vaporized by absorbing a laser having a predetermined wavelength; and
a second doped polysilicon layer disposed on a surface of the laser-absorption layer.

The first doped polysilicon layer and the second doped polysilicon layer have the same doping type, and the second doped polysilicon layer is disposed only on the metal contact region.

In an embodiment, the tunnel oxide layer includes a silicon dioxide layer; and/or a thickness of the tunnel oxide layer is smaller than 3 nm.

In an embodiment, the laser-absorption layer includes a titanium oxide layer or an aluminum oxide layer; and/or a thickness of the laser-absorption layer is in a range from 1 nm to 5 nm.

In an embodiment, a thickness of the second doped polysilicon layer is greater than a thickness of the first doped polysilicon layer.

In an embodiment, the first doped polysilicon layer includes a phosphorus-doped polysilicon film or a boron-doped polysilicon film; and/or a thickness of the first doped polysilicon layer is in a range from 5 nm to 100 nm.

In an embodiment, the second doped polysilicon layer includes a phosphorus-doped polysilicon film or a boron-doped polysilicon film; and/or a thickness of the second doped polysilicon layer is in a range from 70 nm to 200 nm.

In an embodiment, the solar cell further includes a passivation and anti-reflection layer and a metal electrode, wherein the passivation and anti-reflection layer is disposed on the non-metal contact region of the surface of the first doped polysilicon layer and a surface of the second doped polysilicon layer, and the metal electrode is fixedly connected to the second doped polysilicon layer.

In an embodiment, the passivation and anti-reflection layer includes a silicon nitride layer or a stack of an aluminum oxide layer and a silicon nitride layer; and/or a thickness of the passivation and anti-reflection layer is in a range from 70 nm to 80 nm.

According to a second aspect, a method for preparing a solar cell is provided. The method is configured to prepare the solar cell in any one of the embodiments in the first aspect. The method includes:
providing a silicon substrate;
forming a tunnel oxide layer on a surface of the silicon substrate;
forming a first doped polysilicon layer on a surface of the tunnel oxide layer;
forming a laser-absorption layer on a surface of the first doped polysilicon layer;
forming a second doped polysilicon layer on a surface of the laser-absorption layer; and
removing a portion of the laser-absorption layer and a portion of the second doped polysilicon layer by using a laser having a predetermined wavelength, the portion of the laser-absorption layer and the portion of the second doped polysilicon layer being located on a non-metal contact region of the surface of the first doped polysilicon layer, thereby exposing the non-metal contact region of the surface of the first doped polysilicon layer, so as to achieve the solar cell.

The first doped polysilicon layer and the second doped polysilicon layer have the same doping type, and the second doped polysilicon layer is disposed only on the metal contact region.

In an embodiment, the laser is an ultraviolet picosecond laser, and the predetermined wavelength is in a range from 355 nm to 532 nm.

In an embodiment, the method further includes:
forming a passivation and anti-reflection layer on the non-metal contact region of the surface of the first doped polysilicon layer and a surface of the second doped polysilicon layer; and
forming a metal electrode on a region of the passivation and anti-reflection layer, corresponding to the second doped polysilicon layer.

According to a third aspect, a photovoltaic module includes the solar cell in any one of the embodiments in the first aspect.

In the above-described embodiments of the solar cell and the preparation method thereof, the second doped polysilicon layer is only disposed in the metal contact region, thereby achieving passivating contact while reducing blocking and/or absorption of light on the non-metal contact region. Accordingly, on the one hand, the light utilization rate can be improved, and the current loss of the solar cell can be reduced; on the other hand, the charge carrier recombination in the metal contact region and the non-metal contact region can be effectively reduced while desirable contact performance can be achieved, thereby effectively improving the efficiency of the solar cell. Moreover, the laser-absorption layer is disposed between the first doped polysilicon layer and the second doped polysilicon layer, and thus the portion of the laser-absorption layer and the portion of the second doped polysilicon layer located on the non-metal contact region can be removed through laser-induced vaporization due to the intense laser absorption of the laser-absorption layer, obviating the need for masking and chemical etching to remove the portion of the second doped polysilicon layer on the non-metal contact region. Thus, the preparation process of the solar cell is simplified. This method is compatible with the existing mass production process for crystalline silicon solar cells, and only requires to add a laser-etching apparatus, which reduces preparation cost, and facilitates industrialization and mass production. Consequently, the complexity and high cost issues associated with the preparation method of a passivating contact structure employing a selective polysilicon layer can be effectively addressed.

### BRIEF DESCRIPTION OF THE DRAWINGS

FIG. 1 is a schematic view of a solar cell in an embodiment of the present application.
FIG. 2 shows a flowchart of a method for preparing a solar cell in an embodiment of the present application.

### Reference signs:

100. solar cell; 1. silicon substrate; 2. tunnel oxide layer; 3. first doped polysilicon layer; 4. laser-absorption layer; 5. second doped polysilicon layer; 6. passivation and anti-reflection layer; 7. metal electrode.

### DETAILED DESCRIPTION

To make the objectives, features, and advantages of the present application more understandable, detailed description of specific embodiments are provided below, along with accompanying drawings. Many specific details are disclosed in the following description to facilitate a comprehensive understanding of the present application. However, it should be noted that the present application can be implemented in various ways different from those described herein, and those skilled in the art may make improvements without departing from the scope of the appended claims. Therefore, the present application is not limited to the specific embodiments disclosed below.

In the description of the present application, it should be understood that the terms "central", "longitudinal", "transverse", "length", "width", "thickness", "upper", "lower", "front", "rear", "left", "right", "vertical", "horizontal", "top", "bottom", "inner", "outer", "clockwise", "counterclockwise", "axial" , "radial", "circumferential", etc. indicate the orientations or positional relationships on the basis of the drawings. These terms are only for describing the present application and simplifying the description, rather than indicating or implying that the related devices or elements must have the specific orientations, or be constructed or operated in the specific orientations, and therefore cannot be understood as limitations of the present application.

The drawings provided herein are for the purpose of illustration, and the drawings are not necessarily drawn to scale. In addition, the terms "first" and "second" are used merely as labels to distinguish one element having a certain name from another element having the same name, and cannot be understood as indicating or implying any priority, precedence, or order of one element over another, or indicating the quantity of the element. Therefore, the element modified by "first" or "second" may explicitly or implicitly includes at least one of the elements. In the description of the present application, "a plurality of" means at least two, such as two, three, etc., unless otherwise specifically defined.

In the present application, unless otherwise clearly specified and defined, the terms "installed", "connected", "coupled", "fixed" and the like should be interpreted broadly. For example, an element, when being referred to as being "installed", "connected", "coupled", "fixed" to another element, unless otherwise specifically defined, may be fixedly connected, detachably connected, or integrated to the other element, may be mechanically connected or electrically connected to the other element, and may be directly connected to the other element or connected to the other element via an intermediate element. For those of ordinary skill in the art, the specific meaning of the above-mentioned terms in the present application can be understood according to specific circumstances.

In the present application, unless otherwise specifically defined, an element, when being referred to as being located "on" or "under" another element, may be in direct contact with the other element or contact the other element via an intermediate element. Moreover, the element, when being referred to as being located "on", "above", "over" another element, may be located right above or obliquely above the other element, or merely located at a horizontal level higher than the other element; the element, when being referred to as being located "under", "below", "beneath" another element, may be located right below or obliquely below the other element, or merely located at a horizontal level lower than the other element.

It should be noted that an element, when being referred to as being "fixed" or "mounted" to another element, may be directly fixed or mounted to the other element or via an intermediate element. Such terms as "vertical", "horizontal", "up", "down", "left", "right" and the like used herein are for illustrative purposes only and are not meant to be the only ways for implementing the present application.

In a crystalline silicon solar cell, serious charge carrier recombination may exist in a contact region between a metal electrode and a surface of a crystalline silicon wafer (i.e., a metal contact region), leading to an increased recombination current, which significantly hinders the efficiency of the crystalline silicon solar cell from being improved. A tunnel oxide passivating contact structure composed of an ultra-thin tunnel oxide layer and a doped polysilicon layer can significantly reduce the charge carrier recombination in the metal contact region while achieving desirable contact performance, thereby greatly improve the efficiency of the solar cell.

However, in the passivating contact structure of the solar cell, the polysilicon layer exhibits severe parasitic absorption of light, and a thick polysilicon layer formed across the entire surface of the silicon wafer will greatly reduce the utilization rate of light for the solar cell, which decreases the short-circuit current of the solar cell and leads to current loss. Thus, an issue to be promptly addressed is how to effectively reduce the charge carrier recombination both in the metal contact region and in a non-metal contact region, which is the region beyond the metal contact region, while ensuring light utilization rate of the solar cell.

In order to further improve the efficiency of the solar cell, the portion of the polysilicon layer and the portion of the tunnel oxide layer corresponding to the metal electrode can be retained while portions of layers where passivating contact is not achieved can be removed. This structure not only achieves passivating contact but also reduces absorption of light on the non-metal region, and thus is referred to as a passivating contact structure employing a selective polysilicon layer.

In related art, the preparation method of the passivating contact structure employing the selective polysilicon layer may involve chemical etching to remove the portion of the polysilicon layer located on the non-metal contact region or depositing the polysilicon layer only on the metal contact region by using a mask. These methods are complex and will increase the cost, which limit their application in mass production and hinder their popularization in the photovoltaic industry.

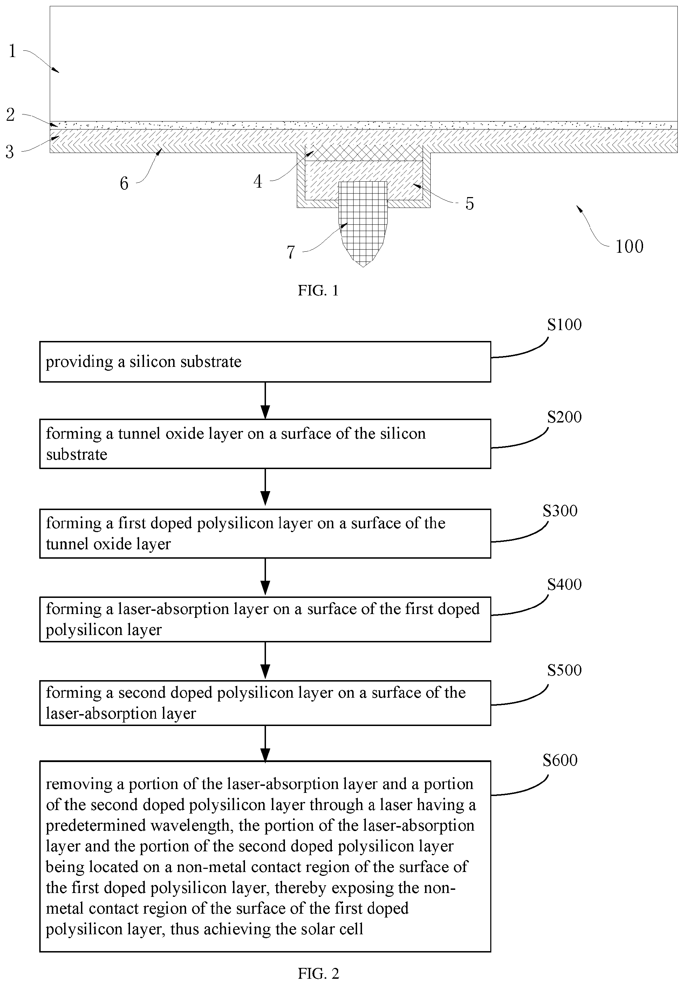

FIG. 1 is a schematic view of a solar cell in an embodiment of the present application. Referring to FIG. 1, in an embodiment of the present application, a solar cell 100 includes a silicon substrate 1, a tunnel oxide layer 2, a first doped polysilicon layer 3, a laser-absorption layer 4, and a second doped polysilicon layer 5. The tunnel oxide layer 2 is disposed on a surface of the silicon substrate 1. The first doped polysilicon layer 3 is disposed on a surface of the tunnel oxide layer 2. A surface of the first doped polysilicon layer 3 includes a metal contact region and a non-metal contact region. The laser-absorption layer 4 is disposed on the metal contact region of the surface of the first doped polysilicon layer 3. The laser-absorption layer 4 is adapted to be vaporized by absorbing a laser having a predetermined wavelength. The second doped polysilicon layer 5 is disposed on a surface of the laser-absorption layer 4.

In the present embodiment, the silicon substrate 1 is adapted to be used in preparing the solar cell 100. The silicon substrate 1 can be a silicon wafer, which can be a monocrystalline silicon wafer or a polysilicon wafer. The silicon substrate 1 includes a front side and a back side. The front side is configured to face the sun (also referred to as a light-receiving side); the back side is configured to be back from the sun (also referred to as a back side). The front side or back side of the silicon substrate 1 can be doped to form a doped surface. The doping type of the doped surface can be either the p-type or the n-type, which is not limited herein.

The doped surface of the silicon substrate 1, the surface of the tunnel oxide layer 2, the surface of the first doped polysilicon layer 3, the surface of the laser-absorption layer 4, and the surface of the second doped polysilicon layer 5 are not adjacent to each other.

The tunnel oxide layer 2 and the first doped polysilicon layer 3 are sequentially formed on one side (i.e., the back side or the front side) of the silicon substrate 1, entirely covering the surface which is opposite to the doped surface. The tunnel oxide layer 2 and the first doped polysilicon layer 3 together form a passivating contact structure, thereby sufficiently passivating the surface of the silicon substrate 1, and reducing the surface recombination. Since the tunnel oxide layer 2 is very thin and the first doped polysilicon layer 3 includes dopant, majority carriers can penetrate these two passivation layers while minority carriers are blocked. The surface of the first doped polysilicon layer 3 can be metallized, such as covered with a metal electrode 7, to achieve passivating contact, while the metal electrode does not have to be in direct contact with the silicon substrate 1 through an opening in the two layers. The surface of the first doped polysilicon layer 3 includes the metal contact region and the non-metal contact region. The metal contact region is the region configured to realize the passivating contact, e.g., the region corresponding to the metal electrode 7, and the non-metal contact region is the region where no passivating contact is required, e.g., the region beyond the metal contact region.

The laser-absorption layer 4 and the second doped polysilicon layer 5 are sequentially stacked on the metal contact region of the surface of the first doped polysilicon layer 3. Therefore, the metal contact region is provided with two doped polysilicon layers, i.e., the first doped polysilicon layer 3 and the second doped polysilicon layer 5 simultaneously, thus forming a relatively thick passivating contact structure, which can effectively enhance the passivation in the metal contact region, and prevent the passivating contact structure from being damaged during the metallization, i.e., the forming of the metal electrode 7. The thick passivating contact structure can significantly reduce the charge carrier recombination in the metal contact region while providing desirable contact performance.

Moreover, the second doped polysilicon layer 5 is disposed only on the metal contact region, which requires the passivating contact, and only the first doped polysilicon layer 3 is formed in the non-metal contact region, which requires no passivating contact. Thus, the polysilicon layer in the non-metal contact region can be relatively thin, so as to form the passivating contact structure employing the selective polysilicon layer, which can reduce blocking and/or absorption of light on the non-metal contact region to improve the light utilization rate, reduce the current loss of the solar cell 100, and thus improve the efficiency of the solar cell 100.

Further, the laser-absorption layer 4 is disposed between the two doped polysilicon layers in the metal contact region. The laser-absorption layer 4 can be an oxide layer having a tunneling effect to ensure the passivating contact effect. Moreover, the laser-absorption layer 4 is adapted to be vaporized by absorbing a laser having a predetermined wavelength, and thus in preparation of the solar cell 100, the portion of the laser-absorption layer 4 located on the non-metal contact region and the portion of the second doped polysilicon layer 5 stacked on the portion of the laser-absorption layer 4 can be removed through laser-induced vaporization due to the intense laser absorption of the laser-absorption layer 4.

The solar cell 100 in the present embodiment can be formed as follows: first, the tunnel oxide layer 2, the first doped polysilicon layer 3, the laser-absorption layer 4, and the second doped polysilicon layer 5 can be sequentially formed on the entire surface of the front side or the back side the silicon substrate 1. Then, the portion of the laser-absorption layer 4 and the portion of the second doped polysilicon layer 5 on the non-metal contact region can be removed through laser etching due to the intense laser absorption and laser-induced vaporization of the laser-absorption layer 4, so as to achieve the solar cell 100 of the present embodiment.

In the present embodiment of the solar cell 100, the second doped polysilicon layer 5 is only disposed in the metal contact region, achieving passivating contact while reducing blocking and/or absorption of light on the non-metal contact region. Accordingly, on the one hand, the light utilization rate can be improved, and the current loss of the solar cell 100 can be reduced, and on the other hand, the charge carrier recombination in the metal contact region and the non-metal contact region can be effectively reduced while desirable contact performance can be achieved, thereby effectively improving the efficiency of the solar cell 100. Moreover, the laser-absorption layer 4 is disposed between the first doped polysilicon layer 3 and the second doped polysilicon layer 5, and thus the portion of the laser-absorption layer 3 and the portion of the second doped polysilicon layer 5 located on the non-metal contact region can be removed through laser-induced vaporization due to the intense laser absorption of the laser-absorption layer 4, obviating the need for masking and chemical etching. Thus, the preparation process of the solar cell 100 is simplified. This method is compatible with the existing mass production process for crystalline silicon solar cells, and only requires to add a laser-etching device, reducing preparation cost, and facilitates industrialization and mass production. Consequently, the complexity and high cost issues associated with the preparation method of a passivating contact structure employing a selective polysilicon layer can be effectively addressed.

In some embodiments, the tunnel oxide layer 2 can include a silicon dioxide layer.

In some embodiments, the tunnel oxide layer 2 has a thickness smaller than 3 nm, enabling a quantum tunneling effect. Optionally, the thickness of the tunnel oxide layer 2 can be in a range from 0.5 nm to 2.5 nm. Further, the thickness of the tunnel oxide layer 2 can be in a range from 1 nm to 2.5 nm. For example, the tunnel oxide layer 2 can have a thickness of 1.5 nm.

In some embodiments, the laser-absorption layer 4 includes a titanium oxide layer or an aluminum oxide layer. Titanium oxide and aluminum oxide can intensely absorb a laser of 355 nm and be vaporized under the action of the laser. Thus, scanning the non-metal contact region with an ultraviolet picosecond laser of 355nm can quickly remove the portion of the laser-absorption layer 4 and the portion of the second doped polysilicon layer 5 on the non-metal contact region. This method is simple, cost effective, and adapted to be industrialized.

In some embodiments, the thickness of the laser-absorption layer 4 can be in a range from 1 nm to 5 nm, enabling the quantum tunneling effect. Further, the thickness of the laser-absorption layer 4 can be in a range from 1 nm to 3 nm. For example, the titanium oxide layer of the laser-absorption layer 4 can have a thickness of 3 nm.

In some embodiments, the thickness of the second doped polysilicon layer 5 can be greater than the thickness of the first doped polysilicon layer 3. By forming the second doped polysilicon layer 5 with a greater thickness on the metal contact region, the passivating contact structure can be prevented from being damaged during forming the metal electrode 7, and effectively reduce the charge carrier recombination in the metal contact region. On the other hand, in the non-metal contact region, the first doped polysilicon layer 3 has a smaller thickness, which is conducive to further reducing the blocking and/or absorption of light on the non-metal contact region, increasing the light utilization rate. Accordingly, the overall passivation by the passivating contact structure, the reduction of light parasitic absorption, and the protection from damage caused by forming the metal electrode can be simultaneously achieved, thereby further improving the efficiency of the solar cell 100.

In some embodiments, the first doped polysilicon layer 3 includes a phosphorus-doped polysilicon film or a boron-doped polysilicon film. In some embodiments, the silicon substrate 1 is an n-type silicon wafer, the first doped polysilicon layer 3 is disposed on an n-type surface of the silicon substrate 1, and for example is the phosphorus-doped polysilicon film. In some other embodiments, the silicon substrate 1 is a p-type silicon wafer, the first doped polysilicon layer 3 is disposed on a p-type surface of the silicon substrate 1, and for example is the boron-doped polysilicon film.

In some embodiments, the thickness of the first doped polysilicon layer 3 is in a range from 5 nm to 100 nm. Further, the thickness of the first doped polysilicon layer 3 is in a range from 10 nm to 50 nm. For example, the first doped polysilicon layer 3 has a thickness of 20 nm.

In some embodiments, the second doped polysilicon layer 5 includes a phosphorus-doped polysilicon film or a boron-doped polysilicon film. In some embodiments, the silicon substrate 1 is an n-type silicon wafer, the second doped polysilicon layer 5 is disposed on the n-type surface of the silicon substrate 1, and for example is the phosphorus-doped polysilicon film. In some other embodiments, the silicon substrate 1 is a p-type silicon wafer, the second doped polysilicon layer 5 is disposed on the p-type surface of the silicon substrate 1, and for example is the boron-doped polysilicon film. The first doped polysilicon layer 3 and the second doped polysilicon layer 5 are only different in thickness, but have the same doping type and/or made of the same material.

In some embodiments, the thickness of the second doped polysilicon layer 5 is in a range from 70 nm to 200 nm. Further, the thickness of the second doped polysilicon layer 5 is in a range from 100 nm to 150 nm. For example, the second doped polysilicon layer 5 has a thickness of 150 nm.

In some embodiments, as shown in FIG. 1, the solar cell 100 further includes a passivation and anti-reflection layer 6 and a metal electrode 7. The passivation and anti-reflection layer 6 is disposed on the non-metal contact region of the surface of the first doped polysilicon layer 3 and the surface of the second doped polysilicon layer 5. The metal electrode 7 is fixedly connected to the second doped polysilicon layer 5. The passivation and anti-reflection layer 6 is adapted to provide field passivation while reducing reflection of incident light, thereby enhancing the light utilization rate and improving the efficiency of the solar cell 100. The metal electrode 7 is configured to collect electric currents. The metal electrode 7 penetrates through the passivation and anti-reflection layer 6 to be in contact with and fixedly connected to the second doped polysilicon layer 5, so as to realize the electrical connection between the metal electrode 7 and the second doped polysilicon layer 5. However, the metal electrode terminates in the second doped polysilicon layer 5, and is separated from the laser-absorption layer 4 by the second doped polysilicon layer 5.

In some embodiments, the passivation and anti-reflection layer 6 can include a silicon nitride layer or a stack of an aluminum oxide layer and a silicon nitride layer. In some embodiments, the thickness of the passivation and anti-reflection layer 6 can be in a range from 70 nm to 80 nm.

In some embodiments, the metal electrode 7 can be a silver electrode or a silver-aluminum electrode.

FIG. 2 shows a flowchart of a method for preparing a solar cell in an embodiment of the present application. Referring to FIG. 2, the method for the solar cell according to an embodiment of the present application is configured to prepare the solar cell in any one of the embodiments described above. The method includes:
S100, providing a silicon substrate;
S200, forming a tunnel oxide layer on a surface of the silicon substrate;
S300, forming a first doped polysilicon layer on a surface of the tunnel oxide layer;
S400, forming a laser-absorption layer on a surface of the first doped polysilicon layer;
S500, forming a second doped polysilicon layer on a surface of the laser-absorption layer; and
S600, removing a portion of the laser-absorption layer and a portion of the second doped polysilicon layer through a laser having a predetermined wavelength, the portion of the laser-absorption layer and the portion of the second doped polysilicon layer being located on a non-metal contact region of the surface of the first doped polysilicon layer, thereby exposing the non-metal contact region of the surface of the first doped polysilicon layer, thus achieving the solar cell.

In the present embodiment, the laser having the predetermined wavelength is adapted to be intensely absorbed by the laser-absorption layer and induce vaporization of the laser-absorption layer. In some embodiments, the laser is an ultraviolet picosecond laser or an ultraviolet nanosecond laser. In preparation of the solar cell, the tunnel oxide layer, the first doped polysilicon layer, the laser-absorption layer, and the second doped polysilicon layer can be sequentially formed on the entire surface of the front side or the back side the silicon substrate. Then, the portion of the laser-absorption layer and the portion of the second doped polysilicon layer on the non-metal contact region can be removed through the laser having the predetermined wavelength under the action of the intense laser absorption and laser-induced vaporization of the laser-absorption layer, thereby exposing the non-metal contact region of the surface of the first doped polysilicon layer, so as to achieve the solar cell of the present embodiment.

Removing the portion of the laser-absorption layer and the portion of the second doped polysilicon layer located on the non-metal contact region by using laser can simplify the preparation process of the selective passivation contact structure of the solar cell, obviating the need for masking and chemical etching. This method is compatible with the existing mass production process for crystalline silicon solar cells, and only requires to add a laser-etching device, reducing preparation cost, facilitating industrialization and mass production. Consequently, the complexity and high cost issues associated with the preparation method of a passivating contact structure employing a selective polysilicon layer can be effectively addressed.

Optionally, the step of providing the silicon substrate can include cleaning the silicon substrate to remove dirt from the surface of the silicon substrate, providing a clean and flat silicon substrate for subsequent use.

Optionally, the tunnel oxide layer can be formed on the surface of the silicon substrate through thermal oxidation. Silicon can be oxidized in air to form an oxide layer, which is referred to as thermal oxidation. Accordingly, a silicon dioxide layer having excellent performance can be formed on the surface of the silicon substrate.

Optionally, the first doped polysilicon layer can be formed through low pressure chemical vapor deposition (LPCVD) or plasma enhanced chemical vapor deposition (PECVD). The PECVD is adapted to be used for forming a high quality film.

Optionally, the predetermined wavelength of the laser can be in a range from 355 nm to 532 nm.

In some embodiments, the laser is an ultraviolet picosecond laser, and the predetermined wavelength is 355 nm. The ultraviolet picosecond laser of 355 nm has a limited thermal effect, a fast speed, and a high processing accuracy.

In some embodiments, the power of the laser can be in a range from 1 W to 10 W, avoiding damage to the silicon substrate and reducing energy consumption.

In some embodiments, the method further includes:
S700, forming a passivation and anti-reflection layer on the non-metal contact region of the surface of the first doped polysilicon layer and a surface of the second doped polysilicon layer; and
S800, forming a metal electrode on a region of the passivation and anti-reflection layer corresponding to the second doped polysilicon layer.

Optionally, the passivation and anti-reflection layer can be formed through chemical vapor deposition or atomic layer deposition (ALD). The atomic layer deposition is a method configured to individually deposit atomic layers of material on a surface of a substrate, realizing a high film formation quality.

Optionally, the metal electrode can be formed on the passivation and anti-reflection layer through screen printing. The metal electrode is printed on the portion of the second doped polysilicon layer retained on the metal contact region.

The preparation method of the solar cell of the present application is further specifically described in a specific example as follows:
A silicon substrate is provided. The silicon substrate is a silicon wafer. The silicon wafer is cleaned.

A tunnel oxide layer is formed on a surface of the silicon substrate. Specifically, a silicon oxide layer having a thickness of 1.5 nm is formed on the surface of the silicon wafer through thermal oxidation.

A first doped polysilicon layer is formed on a surface of the tunnel oxide layer. Specifically, a phosphorus-doped polysilicon film or a boron-doped polysilicon film having a thickness of 20 nm is formed on the surface of the tunnel oxide layer through LPCVD or PECVD.

A laser-absorption layer is formed on a surface of the first doped polysilicon layer. Specifically, a titanium oxide layer having a thickness of 3 nm is formed on the surface of the first doped polysilicon layer through LPCVD or PECVD.

A second doped polysilicon layer is formed on a surface of the laser-absorption layer. Specifically, a phosphorus-doped polysilicon film or a boron-doped polysilicon film having a thickness of 150 nm is formed on the surface of the laser-absorption layer through LPCVD or PECVD.

The portion of the laser-absorption layer and the portion of the second doped polysilicon layer on the non-metal contact region of the surface of the first doped polysilicon layer are removed through a laser having a predetermined wavelength, thereby exposing the non-metal contact region of the surface of the first doped polysilicon layer. Specifically, the second doped polysilicon layer on the non-metal contact region is scanned with a picosecond laser having a wavelength of 355 nm. The titanium oxide layer can intensely absorb the laser of 355 nm and vaporized under the action of the laser. Thus, the laser-absorption layer and the second doped polysilicon layer on the non-metal contact region can be removed.

A passivation and anti-reflection layer is formed. Specifically, a stack of an aluminum oxide layer and a silicon nitride layer or a silicon nitride layer is deposited on the exposed non-metal contact region of the surface of the first doped polysilicon layer and the surface of the second doped polysilicon layer through chemical vapor deposition or atomic layer deposition.

A metal electrode is formed. Specifically, the metal electrode is formed on a surface of the passivation and anti-reflection layer through screen printing, corresponding to the second doped polysilicon layer remained on the metal contact region. The metal electrode is a silver electrode or a silver-aluminum electrode.

The photoelectric conversion efficiency of the solar cell prepared through the method in the present embodiment can be increased by 0.2%.

A photovoltaic module is provided according to an embodiment of the present application. The photovoltaic module includes the solar cell according to any one of the embodiments described above.

As including the solar cell according to any one of the embodiments described above, the photovoltaic module can provide the same effects, which will not be repeated herein.

## Claims

1. A solar cell, comprising:
a silicon substrate (1);
a tunnel oxide layer (2) disposed on a surface of the silicon substrate (2);
a first doped polysilicon layer (3) disposed on a surface of the tunnel oxide layer (2), a surface of the first doped polysilicon layer (3) comprising a metal contact region and a non-metal contact region;
a laser-absorption layer (4) disposed on the metal contact region of the surface of the first doped polysilicon layer (3), the laser-absorption layer (4) being adapted to be vaporized by absorbing a laser having a predetermined wavelength; and
a second doped polysilicon layer (5) disposed on a surface of the laser-absorption layer (4);
wherein the first doped polysilicon layer (3) and the second doped polysilicon layer (5) have the same doping type, and the second doped polysilicon layer (5) is disposed only on the metal contact region.

2. The solar cell according to claim 1, wherein the tunnel oxide layer comprises a silicon dioxide layer; and/or a thickness of the tunnel oxide layer is smaller than 3 nm.

3. The solar cell according to claim 1 or 2, wherein the laser-absorption layer comprises a titanium oxide layer or an aluminum oxide layer; and/or a thickness of the laser-absorption layer is in a range from 1 nm to 5 nm.

4. The solar cell according to any one of claims 1 to 3, wherein a thickness of the second doped polysilicon layer is greater than a thickness of the first doped polysilicon layer.

5. The solar cell according to any one of claims 1 to 4, wherein the first doped polysilicon layer comprises a phosphorus-doped polysilicon film or a boron-doped polysilicon film; and/or a thickness of the first doped polysilicon layer is in a range from 5 nm to 100 nm.

6. The solar cell according to any one of claims 1 to 5, wherein the second doped polysilicon layer comprises a phosphorus-doped polysilicon film or a boron-doped polysilicon film; and/or a thickness of the second doped polysilicon layer is in a range from 70 nm to 200 nm.

7. The solar cell according to any one of claims 1 to 6, further comprising a passivation and anti-reflection layer and a metal electrode, wherein the passivation and anti-reflection layer is disposed on the non-metal contact region of the surface of the first doped polysilicon layer and a surface of the second doped polysilicon layer, and the metal electrode is fixedly connected to the second doped polysilicon layer.

8. The solar cell according to claim 7, wherein the passivation and anti-reflection layer comprises a silicon nitride layer or a stack of an aluminum oxide layer and a silicon nitride layer; and/or a thickness of the passivation and anti-reflection layer is in a range from 70 nm to 80 nm.

9. The solar cell according to claim 7 or 8, wherein the metal electrode penetrates through the passivation and anti-reflection layer and is in contact with the second doped polysilicon layer.

10. The solar cell according to any one of claims 7 to 9, wherein the metal electrode is separated from the laser-absorption layer by the second doped polysilicon layer.

11. The solar cell according to any one of claims 1 to 10, wherein the first doped polysilicon layer and the second doped polysilicon layer are made of the same material.

12. A photovoltaic module comprising the solar cell according to any one of claims 1 to 11.

13. A method for preparing the solar cell according to any one of claims 1 to 11, the method comprising:
providing (S100) a silicon substrate;
forming (S200) a tunnel oxide layer on a surface of the silicon substrate;
forming (S300) a first doped polysilicon layer on a surface of the tunnel oxide layer;
forming (S400) a laser-absorption layer on a surface of the first doped polysilicon layer;
forming (S500) a second doped polysilicon layer on a surface of the laser-absorption layer; and
removing (S600) a portion of the laser-absorption layer and a portion of the second doped polysilicon layer by using a laser having a predetermined wavelength, the portion of the laser-absorption layer and the portion of the second doped polysilicon layer being located on a non-metal contact region of the surface of the first doped polysilicon layer, thereby exposing the non-metal contact region of the surface of the first doped polysilicon layer;
wherein the first doped polysilicon layer and the second polysilicon layer have the same doping type.

14. The method according to claim 13, wherein the laser is an ultraviolet picosecond laser, and the predetermined wavelength is in a range from 355 nm to 532 nm.

15. The method according to claim 13 or 14, further comprising:
forming a passivation and anti-reflection layer on the non-metal contact region of the surface of the first doped polysilicon layer and a surface of the second doped polysilicon layer; and
forming a metal electrode on a region of the passivation and anti-reflection layer, corresponding to the second doped polysilicon layer.

## Patentansprüche

1. Solarzelle, umfassend:
ein Siliziumsubstrat (1);
eine Tunneloxidschicht (2), die auf einer Oberfläche des Siliziumsubstrats (1) angeordnet ist;
eine erste dotierte Polysiliziumschicht (3), die auf einer Oberfläche der Tunneloxidschicht (2) angeordnet ist, wobei eine Oberfläche der ersten dotierten Polysiliziumschicht (3) einen Metallkontaktbereich und einen Nicht-Metallkontaktbereich umfasst;
eine Laserabsorptionsschicht (4), die auf dem Metallkontaktbereich der Oberfläche der ersten dotierten Polysiliziumschicht (3) angeordnet ist, wobei die Laserabsorptionsschicht (4) ausgelegt ist, um durch Absorption eines Lasers mit einer vorbestimmten Wellenlänge verdampft zu werden; und
eine zweite dotierte Polysiliziumschicht (5), die auf einer Oberfläche der Laserabsorptionsschicht (4) angeordnet ist;
wobei die erste dotierte Polysiliziumschicht (3) und die zweite dotierte Polysiliziumschicht (5) denselben Dotierungstyp aufweisen, und die zweite dotierte Polysiliziumschicht (5) nur auf dem Metallkontaktbereich angeordnet ist.

2. Solarzelle nach Anspruch 1, wobei die Tunneloxidschicht eine Siliziumdioxidschicht umfasst; und/oder eine Dicke der Tunneloxidschicht kleiner als 3 nm ist.

3. Solarzelle nach Anspruch 1 oder 2, wobei die Laserabsorptionsschicht eine Titanoxidschicht oder eine Aluminiumoxidschicht umfasst; und/oder eine Dicke der Laserabsorptionsschicht in einem Bereich von 1 nm bis 5 nm liegt.

4. Solarzelle nach einem der Ansprüche 1 bis 3, wobei eine Dicke der zweiten dotierten Polysiliziumschicht größer als eine Dicke der ersten dotierten Polysiliziumschicht ist.

5. Solarzelle nach einem der Ansprüche 1 bis 4, wobei die erste dotierte Polysiliziumschicht einen phosphordotierten Polysiliziumfilm oder einen bordotierten Polysiliziumfilm umfasst; und/oder eine Dicke der ersten dotierten Polysiliziumschicht in einem Bereich von 5 nm bis 100 nm liegt.

6. Solarzelle nach einem der Ansprüche 1 bis 5, wobei die zweite dotierte Polysiliziumschicht einen phosphordotierten Polysiliziumfilm oder einen bordotierten Polysiliziumfilm umfasst; und/oder eine Dicke der zweiten dotierten Polysiliziumschicht in einem Bereich von 70 nm bis 200 nm liegt.

7. Solarzelle nach einem der Ansprüche 1 bis 6, ferner umfassend eine Passivierungs- und Antireflexionsschicht und eine Metallelektrode, wobei die Passivierungs- und Antireflexionsschicht auf dem Nicht-Metallkontaktbereich der Oberfläche der ersten dotierten Polysiliziumschicht und einer Oberfläche der zweiten dotierten Polysiliziumschicht angeordnet ist, und die Metallelektrode fest mit der zweiten dotierten Polysiliziumschicht verbunden ist.

8. Solarzelle nach Anspruch 7, wobei die Passivierungs- und Antireflexionsschicht eine Siliziumnitridschicht oder einen Stapel aus einer Aluminiumoxidschicht und einer Siliziumnitridschicht umfasst; und/oder eine Dicke der Passivierungs- und Antireflexionsschicht in einem Bereich von 70 nm bis 80 nm liegt.

9. Solarzelle nach Anspruch 7 oder 8, wobei die Metallelektrode durch die Passivierungs- und Antireflexionsschicht hindurchdringt und in Kontakt mit der zweiten dotierten Polysiliziumschicht steht.

10. Solarzelle nach einem der Ansprüche 7 bis 9, wobei die Metallelektrode von der Laserabsorptionsschicht durch die zweite dotierte Polysiliziumschicht getrennt ist.

11. Solarzelle nach einem der Ansprüche 1 bis 10, wobei die erste dotierte Polysiliziumschicht und die zweite dotierte Polysiliziumschicht aus demselben Material hergestellt sind.

12. Photovoltaikmodul, das die Solarzelle nach einem der Ansprüche 1 bis 11 umfasst.

13. Verfahren zum Herstellen der Solarzelle nach einem der Ansprüche 1 bis 11, wobei das Verfahren umfasst:
Bereitstellen (S100) eines Siliziumsubstrats;
Bilden (S200) einer Tunneloxidschicht auf einer Oberfläche des Siliziumsubstrats;
Bilden (S300) einer ersten dotierten Polysiliziumschicht auf einer Oberfläche der Tunneloxidschicht;
Bilden (S400) einer Laserabsorptionsschicht auf einer Oberfläche der ersten dotierten Polysiliziumschicht;
Bilden (S500) einer zweiten dotierten Polysiliziumschicht auf einer Oberfläche der Laserabsorptionsschicht; und
Entfernen (S600) eines Abschnitts der Laserabsorptionsschicht und eines Abschnitts der zweiten dotierten Polysiliziumschicht unter Verwendung eines Lasers mit einer vorbestimmten Wellenlänge, wobei sich der Abschnitt der Laserabsorptionsschicht und der Abschnitt der zweiten dotierten Polysiliziumschicht auf einem Nicht-Metallkontaktbereich der Oberfläche der ersten dotierten Polysiliziumschicht befinden, wodurch der Nicht-Metallkontaktbereich der Oberfläche der ersten dotierten Polysiliziumschicht freigelegt wird;
wobei die erste dotierte Polysiliziumschicht und die zweite Polysiliziumschicht denselben Dotierungstyp aufweisen.

14. Verfahren nach Anspruch 13, wobei der Laser ein Ultraviolett-Pikosekunden-Laser ist und die vorbestimmte Wellenlänge in einem Bereich von 355 nm bis 532 nm liegt.

15. Verfahren nach Anspruch 13 oder 14, ferner umfassend:
Bilden einer Passivierungs- und Antireflexionsschicht auf dem Nicht-Metallkontaktbereich der Oberfläche der ersten dotierten Polysiliziumschicht und einer Oberfläche der zweiten dotierten Polysiliziumschicht; und
Bilden einer Metallelektrode auf einem Bereich der Passivierungs- und Antireflexionsschicht, der der zweiten dotierten Polysiliziumschicht entspricht.

## Revendications

1. Cellule solaire, comprenant :
un substrat de silicium (1) ;
une couche d'oxyde tunnel (2) disposée sur une surface du substrat de silicium (1) ;
une première couche de silicium polycristallin dopée (3) disposée sur une surface de la couche d'oxyde tunnel (2), une surface de la première couche de silicium polycristallin dopée (3) comprenant une région de contact métallique et une région de contact non métallique ;
une couche d'absorption laser (4) disposée sur la région de contact métallique de la surface de la première couche de silicium polycristallin dopée (3), la couche d'absorption laser (4) étant conçue pour être vaporisée en absorbant un laser ayant une longueur d'onde prédéterminée ; et
une seconde couche de silicium polycristallin dopée (5) disposée sur une surface de la couche d'absorption laser (4) ;
dans laquelle la première couche de silicium polycristallin dopée (3) et la seconde couche de silicium polycristallin dopée (5) ont le même type de dopage, et la seconde couche de silicium polycristallin dopée (5) est disposée uniquement sur la région de contact métallique.

2. Cellule solaire selon la revendication 1, dans laquelle la couche d'oxyde tunnel comprend une couche de dioxyde de silicium ; et/ou une épaisseur de la couche d'oxyde tunnel est inférieure à 3 nm.

3. Cellule solaire selon la revendication 1 ou 2, dans laquelle la couche d'absorption laser comprend une couche d'oxyde de titane ou une couche d'oxyde d'aluminium ; et/ou une épaisseur de la couche d'absorption laser est comprise entre 1 nm et 5 nm.

4. Cellule solaire selon l'une quelconque des revendications 1 à 3, dans laquelle une épaisseur de la seconde couche de silicium polycristallin dopée est supérieure à une épaisseur de la première couche de silicium polycristallin dopée.

5. Cellule solaire selon l'une quelconque des revendications 1 à 4, dans laquelle la première couche de silicium polycristallin dopée comprend un film de silicium polycristallin dopé au phosphore ou un film de silicium polycristallin dopé au bore ; et/ou une épaisseur de la première couche de silicium polycristallin dopée est comprise entre 5 nm et 100 nm.

6. Cellule solaire selon l'une quelconque des revendications 1 à 5, dans laquelle la seconde couche de silicium polycristallin dopée comprend un film de silicium polycristallin dopé au phosphore ou un film de silicium polycristallin dopé au bore ; et/ou une épaisseur de la seconde couche de silicium polycristallin dopée est comprise entre 70 nm et 200 nm.

7. Cellule solaire selon l'une quelconque des revendications 1 à 6, comprenant en outre une couche de passivation et antireflet et une électrode métallique, dans laquelle la couche de passivation et antireflet est disposée sur la région de contact non métallique de la surface de la première couche de silicium polycristallin dopée et une surface de la seconde couche de silicium dopée, et l'électrode métallique est connectée de manière fixe à la seconde couche de silicium polycristallin dopée.

8. Cellule solaire selon la revendication 7, dans laquelle la couche de passivation et antireflet comprend une couche de nitrure de silicium ou un empilement d'une couche d'oxyde d'aluminium et d'une couche de nitrure de silicium ; et/ou une épaisseur de la couche de passivation et antireflet est comprise entre 70 nm et 80 nm.

9. Cellule solaire selon la revendication 7 ou 8, dans laquelle l'électrode métallique pénètre à travers la couche de passivation et antireflet et est en contact avec la seconde couche de silicium polycristallin dopée.

10. Cellule solaire selon l'une quelconque des revendications 7 à 9, dans laquelle l'électrode métallique est séparée de la couche d'absorption laser par la seconde couche de silicium polycristallin dopée.

11. Cellule solaire selon l'une quelconque des revendications 1 à 10, dans laquelle la première couche de silicium polycristallin dopée et la seconde couche de silicium polycristallin dopée sont constituées du même matériau.

12. Module photovoltaïque comprenant la cellule solaire selon l'une quelconque des revendications 1 à 11.

13. Procédé de préparation de la cellule solaire selon l'une quelconque des revendications 1 à 11, le procédé comprenant :
la fourniture (S100) d'un substrat de silicium ;
la formation (S200) d'une couche d'oxyde tunnel sur une surface du substrat de silicium ;
la formation (S300) d'une première couche de silicium polycristallin dopée sur une surface de la couche d'oxyde tunnel ;
la formation (S400) d'une couche d'absorption laser sur une surface de la première couche de silicium polycristallin dopée ;
la formation (S500) d'une seconde couche de silicium polycristallin dopée sur une surface de la couche d'absorption laser ; et
le retrait (S600) d'une partie de la couche d'absorption laser et d'une partie de la seconde couche de silicium polycristallin dopée à l'aide d'un laser ayant une longueur d'onde prédéterminée, la partie de la couche d'absorption laser et la partie de la seconde couche de silicium polycristallin dopée étant situées sur une région de contact non métallique de la surface de la première couche de silicium polycristallin dopée, exposant ainsi la région de contact non métallique de la surface de la première couche de silicium polycristallin dopée ;
dans lequel la première couche de silicium polycristallin dopée et la seconde couche de silicium polycristallin ont le même type de dopage.

14. Procédé selon la revendication 13, dans lequel le laser est un laser picoseconde ultraviolet, et la longueur d'onde prédéterminée se situe dans une plage allant de 355 nm à 532 nm.

15. Procédé selon la revendication 13 ou 14, comprenant en outre :
la formation d'une couche de passivation et antireflet sur la région de contact non métallique de la surface de la première couche de silicium polycristallin dopée et une surface de la seconde couche de silicium polycristallin dopée ; et
la formation d'une électrode métallique sur une région de la couche de passivation et antireflet, correspondant à la seconde couche de silicium polycristallin dopée.
